# FASCICULE DE BREVET EUROPEEN

(11) **EP 3 594 951 B1**
(45) Date de publication et mention de la délivrance du brevet: **04.08.2021**
(21) Numéro de dépôt: 19186100.4
(22) Date de dépôt: 12.07.2019
(51) Int. Cl.: G11C 11/412, G11C 11/417, G11C 7/20, G11C 7/24, H01L 27/06, H01L 27/11

(54) **MEMOIRE SRAM / ROM RECONFIGURABLE PAR POLARISATION DE SUBSTRAT**
SRAM-/ROM-SPEICHER, DER DURCH SUBSTRATVORSPANNUNG REKONFIGURIERBAR IST
SRAM/ROM MEMORY RECONFIGURABLE BY POLARISATION OF SUBSTRATE

(30) Priorité: 13.07.2018 FR 1856514
(43) Date de publication de la demande: 15.01.2020
(73) Titulaire: Commissariat à l'énergie atomique et aux énergies alternatives, 75015 Paris (FR)
(72) Inventeur: CORIAT, David, 38054 GRENOBLE CEDEX 09 (FR); MAKOSIEJ, Adam, 38054 GRENOBLE CEDEX 09 (FR)
(74) Mandataire: Brevalex

(56) Documents cités:
- EP-A1- 1 939 888
- EP-A1- 2 131 396
- US-A- 5 040 143
- US-B1- 8 995 178
- DONGSOO LEE ET AL: "Area Efficient ROM-Embedded SRAM Cache", IEEE TRANSACTIONS ON VERY LARGE SCALE INTEGRATION (VLSI) SYSTEMS, IEEE SERVICE CENTER, PISCATAWAY, NJ, USA, vol. 21, no. 9, 1 septembre 2013 (2013-09-01), pages 1583-1595, XP011522591, ISSN: 1063-8210, DOI: 10.1109/TVLSI.2012.2217514

## Description

### DOMAINE TECHNIQUE ET ART ANTÉRIEUR

L'invention se rapporte au domaine des mémoires statiques à accès aléatoires SRAM (SRAM pour « Static Random Access Memory »), et concerne plus particulièrement celui des mémoires, dotées de cellules ayant une structure de SRAM, et susceptibles également d'intégrer une fonction de mémoire ROM pour (« Read-Only Memory » ou « mémoire en lecture seule »).

Dans ce domaine, le document US 5365475 présente une cellule mémoire ayant une structure de SRAM à 6 transistors susceptible, à l'aide d'une ligne d'alimentation supplémentaire et d'une ligne de masse supplémentaire, d'être utilisée, par le biais d'une polarisation figée de ses transistors comme une cellule de mémoire ROM. Le comportement en mode ROM ou SRAM conventionnel de la cellule est figé, lors de la fabrication de la mémoire, en choisissant la manière dont celle-ci est connectée aux lignes d'alimentation et lignes de masses.

Par ailleurs, pour effectuer son démarrage, un système numérique utilise des données qui sont typiquement stockées dans un espace d'une mémoire ROM. Une fois ce démarrage effectué, pendant le fonctionnement du système, cet espace mémoire ROM est généralement inutilisé.

Le document « Area Efficient ROM-Embedded SRAM Cache », de Dongsoo Lee et al., IEEE Transactions on VLSI systems, vol. 21, n°9, 2013 présente quant à lui une mémoire formée à partir de cellules SRAM aptes à fonctionner selon un mode mémoire SRAM conventionnel lors duquel les cellules sont accessibles en lecture et en écriture, et susceptibles également d'adopter un autre mode de fonctionnement lors duquel elles sont accessibles en lecture seule. Le passage d'un mode à l'autre, est réalisé à l'aide d'une ligne de mot supplémentaire dont on modifie la polarisation. Cette ligne de mot supplémentaire nécessite une modification substantielle des circuits de commande externes à la matrice de cellules, et en particulier du pilote de lignes de mots et de la logique de contrôle associée.

Le document EP 2131396 décrit une cellule de mémoire SRAM à transistors intégrés sur plusieurs niveaux.

Le document US 8995178 décrit un dispositif mémoire reconfigurable ROM/RAM.

D'une manière générale, dans le domaine de la microélectronique et en particulier celui des mémoires, on cherche continuellement à augmenter la densité de transistors.

Il se pose donc le problème de réaliser un dispositif mémoire amélioré avantageusement doté d'une fonctionnalité de mémoire ROM et qui soit amélioré vis-à-vis d'inconvénients mentionnés ci-dessus, en particulier qui soit reconfigurable ou réutilisable, avec une densité d'intégration améliorée, et ne nécessite pas une modification substantielle de circuits de commande externes.

### EXPOSÉ DE L'INVENTION

Selon un mode de réalisation, on prévoit un dispositif microélectronique doté de plusieurs niveaux superposés de composants et comportant :
- un niveau inférieur doté d'un ou plusieurs composants électroniques formés dans au moins une première couche semi-conductrice,
- un niveau supérieur comprenant des transistors ayant des régions de canal respectives formées dans au moins une deuxième couche semi-conductrice disposée au-dessus de la première couche semi-conductrice, le dispositif comprenant :
   - un ensemble de cellules mémoires dotées chacune d'un premier inverseur et d'un deuxième inverseur connectés de façon croisée, le premier inverseur et le deuxième inverseur étant connectés à et agencés entre une ligne d'alimentation et une ligne de masse,
   le premier inverseur et le deuxième inverseur comprenant respectivement au moins un premier transistor d'un premier type, N ou P, et au moins un deuxième transistor dudit premier type N ou P, appartenant audit niveau supérieur et ayant chacun une électrode inférieure située entre la deuxième couche semi-conductrice et la première couche semi-conductrice et couplée par couplage capacitif avec une région de canal située dans la deuxième couche semi-conductrice,
   lesdites cellules dudit ensemble étant connectées en outre à :
   - une première ligne de polarisation de l'une parmi l'électrode inférieure du premier transistor et l'électrode inférieure du deuxième transistor,
   - une deuxième ligne de polarisation de l'autre parmi l'électrode inférieure du premier transistor et l'électrode inférieure du deuxième transistor,
   le dispositif comprenant en outre un circuit configuré pour lors d'une séquence d'initialisation :
   - pendant une première phase appliquer un premier potentiel et un deuxième potentiel différent du premier potentiel, respectivement sur ladite première ligne de polarisation et ladite deuxième ligne de polarisation, et appliquer une tension entre ladite ligne d'alimentation et la ligne de masse, de sorte à imposer à chaque cellule dudit ensemble une donnée logique dont la valeur dépend de la ligne de polarisation parmi lesdites lignes de polarisation à laquelle l'électrode inférieure de son premier transistor et l'électrode inférieure de son deuxième transistor sont respectivement connectées,
      puis
   - pendant une deuxième phase appliquer un même potentiel nominal sur la première ligne de polarisation et la deuxième ligne de polarisation, et maintenir une tension entre ladite ligne d'alimentation et ladite ligne de masse, de sorte à conserver cette donnée logique et rendre les cellules dudit ensemble accessibles en lecture et en écriture,
   une première cellule dudit ensemble étant connectée aux premières ligne de polarisation et deuxième ligne de polarisation par l'intermédiaire d'une paire de vias, une deuxième cellule dudit ensemble et appartenant à une même rangée de cellules que ladite première cellule étant connectée aux première ligne de polarisation et deuxième ligne de polarisation par l'intermédiaire d'une autre paire de vias.

Le premier potentiel et le deuxième potentiel appliqués lors de la séquence d'initialisation sont prévus de sorte à réaliser une polarisation dissymétrique entre le premier transistor et le deuxième transistor et par conséquent déséquilibrée d'un inverseur par rapport à l'autre de chaque cellule dudit ensemble pour imposer à ces cellules des données de pré-charge.

Sans devoir nécessairement modifier le décodeur de lignes interne de la mémoire et tout en permettant d'augmenter la densité d'intégration, ce circuit permet d'utiliser lesdites cellules mémoires comme des cellules de mémoire ROM, puis, d'utiliser ces cellules comme cellules de mémoire SRAM fonctionnant de manière conventionnelle.

De par la séquence de potentiels appliqués pendant la première phase puis pendant la deuxième phase sur les électrodes arrière, la ligne d'alimentation, la ligne de masse, l'ensemble de cellules peut être reconfiguré automatiquement du mode de fonctionnement avec une donnée pré-chargée lors de l'initialisation à un mode de fonctionnement SRAM conventionnel.

Au départ de la séquence de programmation et de sa première phase, la différence de potentiels entre la ligne d'alimentation et la ligne de masse est avantageusement maintenue nulle afin d'effacer la cellule. Pendant la première phase une mise sous tension est alors opérée et une différence de potentiels entre la ligne d'alimentation et la ligne de masse est ainsi appliquée. Lors de la deuxième phase, une différence de potentiels est maintenue entre la ligne d'alimentation et la ligne de masse.

La valeur de la donnée pré-chargée dans une cellule dudit ensemble lors de la séquence d'initialisation dépend de la manière dont la cellule est connectée par rapport aux lignes de polarisation.

Ainsi, au moins une première cellule dudit ensemble peut avoir une électrode inférieure de son premier transistor qui est connectée à la première ligne de polarisation et une électrode inférieure du deuxième transistor qui est connectée à la deuxième ligne de polarisation, tandis qu'au moins une deuxième cellule dudit ensemble a une électrode inférieure de son premier transistor qui est connectée à la deuxième ligne de polarisation et une électrode inférieure de son deuxième transistor qui est connectée à la première ligne de polarisation, de sorte que lors de ladite séquence d'initialisation, une première donnée logique est imposée à la première cellule, et une deuxième donnée logique, complémentaire de la première donnée est imposée à la deuxième cellule.

Typiquement, les cellules dudit ensemble comprennent respectivement au moins un troisième transistor et au moins un quatrième transistor, le troisième transistor et le quatrième transistor étant d'un deuxième type, P ou N, opposé au premier type, le troisième transistor et le quatrième transistor appartenant audit niveau supérieur et ayant chacun une électrode inférieure située entre la deuxième couche semi-conductrice et la première couche semi-conductrice et couplée par couplage capacitif avec une région de canal située dans la deuxième couche semi-conductrice. Ainsi, on peut utiliser ces électrodes inférieures des troisième et quatrième transistors afin d'augmenter le déséquilibre de polarisation entre les transistors que l'on met en œuvre lors de la séquence d'initialisation afin d'imposer une donnée de pré-charge aux cellules dudit ensemble.

Avantageusement, lesdites cellules dudit ensemble peuvent être connectées en outre à :
- au moins une troisième ligne de polarisation de l'une parmi l'électrode inférieure du troisième transistor et l'électrode inférieure du quatrième transistor,
- au moins une quatrième ligne de polarisation de l'autre parmi l'électrode inférieure du troisième transistor et l'électrode inférieure du quatrième transistor.

Dans ce cas, ledit circuit peut être configuré pour lors de ladite première phase de la séquence d'initialisation :
- appliquer un couple de potentiels différents, respectivement sur ladite troisième ligne de polarisation et ladite quatrième ligne de polarisation, puis
- lors de la deuxième phase appliquer un même potentiel nominal sur la troisième ligne de polarisation et la quatrième ligne de polarisation.

Le premier transistor et le deuxième transistor peuvent être :
- respectivement, un premier transistor de charge et un deuxième transistor de charge de type P, ou
- respectivement, un premier transistor de conduction et un deuxième transistor de conduction de type N.

Selon une possibilité de mise en œuvre, lorsque le premier transistor et le deuxième transistor sont respectivement, un premier transistor de charge et un deuxième transistor de charge de type P, les cellules dudit ensemble peuvent être chacune dotées d'un premier transistor de conduction ayant une grille connectée à une grille du premier transistor de charge et d'un deuxième transistor de conduction ayant une grille connectée à une grille du deuxième transistor de charge, les transistors de conduction étant munis d'une électrode inférieure couplée par couplage capacitif avec une région de canal. Durant la première phase de la séquence d'initialisation les électrodes inférieures respectivement dudit premier transistor de conduction et dudit deuxième transistor de conduction peuvent être alors mises à un même potentiel nominal VNBB ou mises respectivement à un troisième potentiel et à un quatrième potentiel.

Selon une autre possibilité de mise en œuvre, lorsque le premier transistor et le deuxième transistor sont respectivement, un premier transistor de conduction et un deuxième transistor de conduction de type N, les cellules dudit ensemble peuvent être chacune dotées d'un premier transistor de charge ayant une grille connectée à une grille du premier transistor de conduction et d'un deuxième transistor de charge ayant une grille connectée à une grille du deuxième transistor de conduction, les transistors de conduction étant munis d'une électrode inférieure couplée par couplage capacitif avec une région de canal. Les électrodes inférieures respectivement dudit premier transistor de charge et dudit deuxième transistor de charge peuvent être mises durant la première phase de la séquence d'initialisation : à un même potentiel nominal VPBB ou respectivement à un troisième potentiel et à un quatrième potentiel.

Les cellules dudit ensemble peuvent être dotées en outre d'un premier transistor d'accès au premier nœud et d'un deuxième transistor d'accès au deuxième nœud. Avantageusement, le premier transistor d'accès et le deuxième transistor d'accès sont dotés chacun d'une électrode inférieure située entre la deuxième couche semi-conductrice et la première couche semi-conductrice et couplée par couplage capacitif avec une région de canal située dans la deuxième couche semi-conductrice.

Dans ce cas, les électrodes inférieures respectivement dudit premier transistor d'accès et dudit deuxième transistor d'accès peuvent être durant la première phase de la séquence d'initialisation mises à un même potentiel inférieur ou égal à ou être mises respectivement au premier potentiel et au deuxième potentiel lorsque le premier transistor d'accès et le deuxième transistor d'accès sont du premier type, ou peuvent être mises respectivement au troisième potentiel et au quatrième potentiel lorsque le premier transistor d'accès et le deuxième transistor d'accès sont des transistors du deuxième type, P ou N opposé au premier type.

Avantageusement, ledit circuit peut comprendre : un élément interrupteur entre une portion apte à recevoir une tension d'alimentation VDD et la ligne d'alimentation, l'élément interrupteur étant configuré pour alternativement déconnecter puis connecter la portion à la ligne d'alimentation suite à un changement d'état d'un premier signal de commande.

Selon une autre possibilité de mise en œuvre, ledit circuit peut comprendre : une portion recevant une tension d'alimentation VDD, au moins une cellule à retard étant disposée entre ladite portion et ladite ligne d'alimentation.

L'ensemble de cellules mémoire appartient à un dispositif mémoire.

Avantageusement, ce dispositif mémoire comprend en outre un module de conversion d'adresse mémoire virtuelle en adresse mémoire physique. Ce module de conversion peut être doté d'un décodeur configuré pour : à partir d'une adresse virtuelle, produire un signal indicateur d'un premier type d'accès mémoire à des données pré-chargées dans ledit ensemble de cellule lors de ladite séquence d'initialisation ou un signal indicateur d'un deuxième type d'accès mémoire à des données écrites dans ledit ensemble de cellule après ladite séquence d'initialisation et transmettre cette adresse virtuelle à un module de décalage, le module de décalage étant configuré pour appliquer une opération de décalage à une adresse virtuelle afin de produire une adresse physique.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

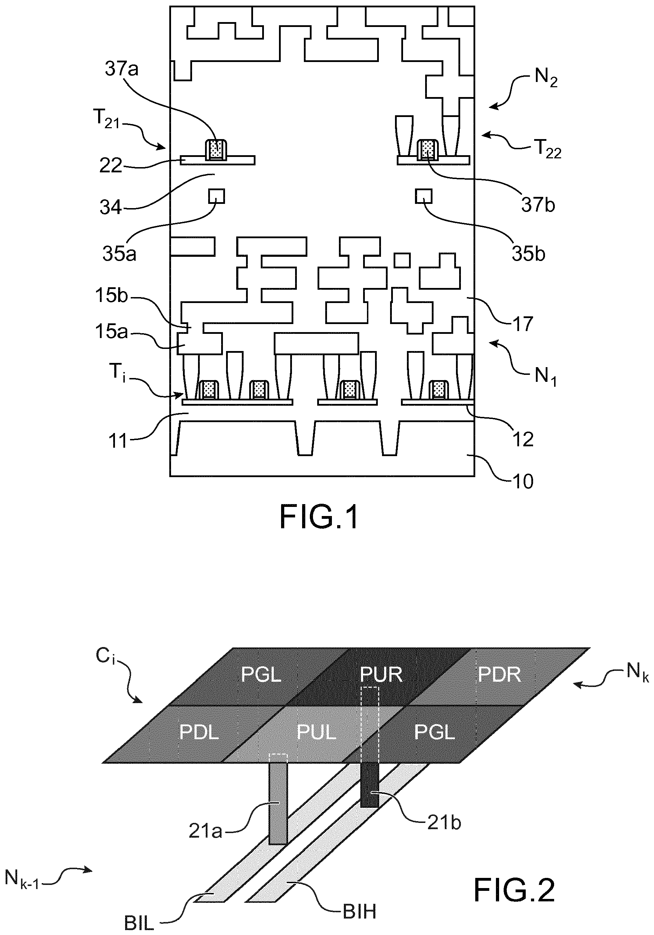

la figure 1 sert à illustrer un exemple d'agencement particulier de transistors d'inverseurs d'une cellule SRAM qui est formée dans un niveau supérieur d'un dispositif à plusieurs niveaux superposés de composants, les transistors étant dotés d'électrodes arrière de polarisation distinctes et qui peuvent être polarisées indépendamment l'une de l'autre, et permettent, lors d'une séquence d'initialisation, d'imposer une donnée logique à cette cellule selon une manière qui diffère d'une opération d'écriture conventionnelle ;
- la figure 2 sert à illustrer un exemple d'agencement particulier de lignes conductrices de polarisation vis-à-vis des électrodes arrière de transistors d'une première cellule mémoire pour imposer à cette première cellule, lors d'une séquence d'initialisation, une donnée logique dite « de pré-charge » dont la valeur dépend de cet agencement ;

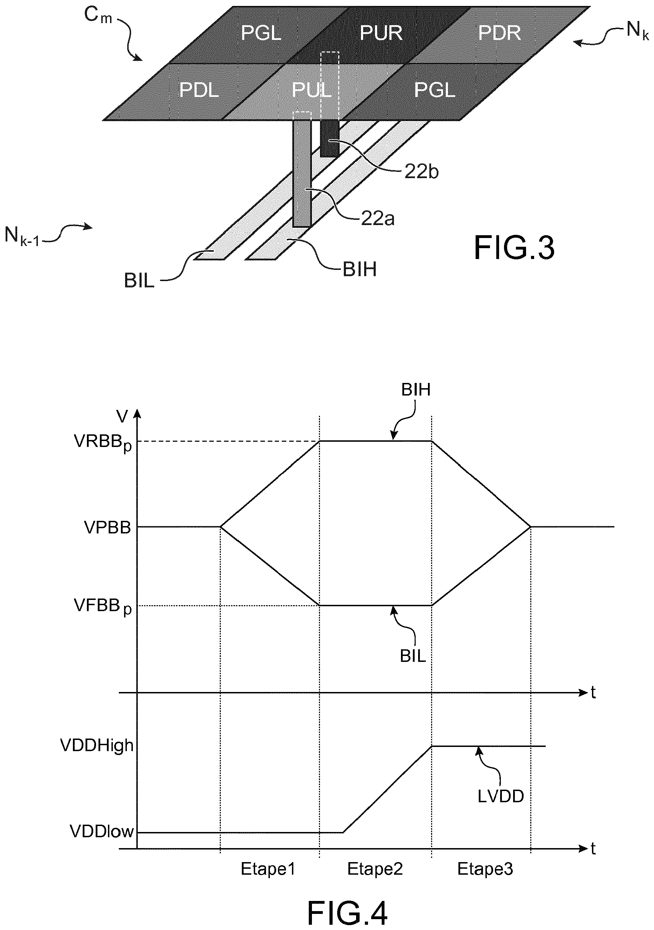

- la figure 3 sert à illustrer un exemple d'agencement différent, dans une deuxième cellule, des lignes conductrices de polarisation vis-à-vis des électrodes arrière de transistors pour imposer à cette deuxième cellule, lors d'une séquence d'initialisation, une donnée logique complémentaire de celle imposée à la première cellule ;
- la figure 4 donne un exemple de séquence de signaux de polarisation et d'alimentation susceptibles d'être appliqués aux inverseurs d'une cellule SRAM pour lui imposer une donnée logique de pré-charge qui dépend de la manière dont elle est connectée aux lignes conductrices de polarisation, puis lui faire adopter un mode de fonctionnement de SRAM ;

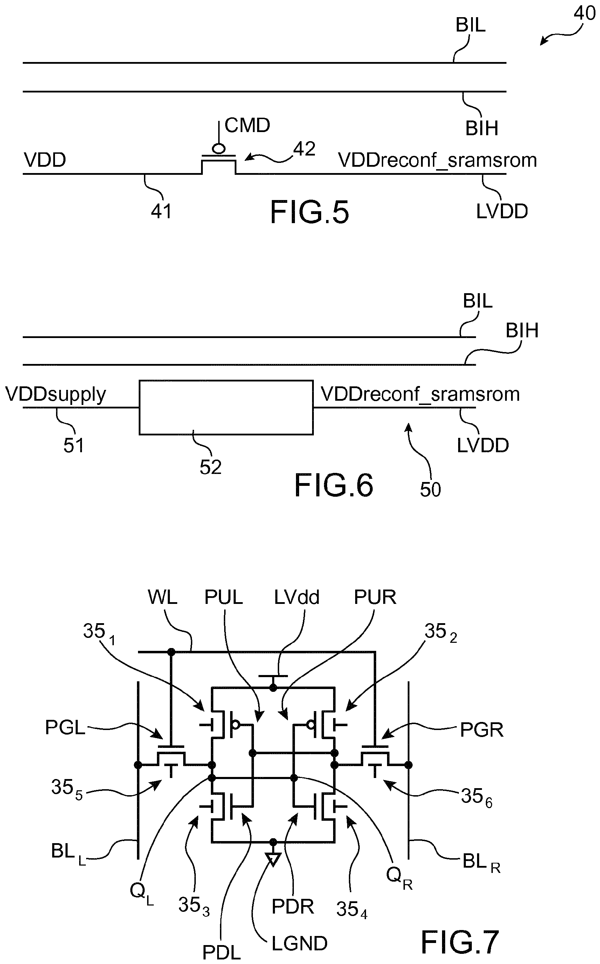

- la figure 5 sert à illustrer un exemple de circuit apte à appliquer une telle séquence de signaux ;
- la figure 6 donne un autre exemple de circuit apte à appliquer une telle séquence de signaux ;
- la figure 7 donne un schéma électrique équivalent d'une cellule SRAM dont les transistors sont munis d'électrodes de polarisation arrière, la cellule ayant une ligne d'alimentation dont la mise sous tension est susceptible d'être retardée afin de permettre de l'initialiser à une valeur de pré-charge prédéterminée en fonction de sa connexion par rapport aux lignes de polarisation puis de l'utiliser comme une cellule de mémoire SRAM conventionnelle ;

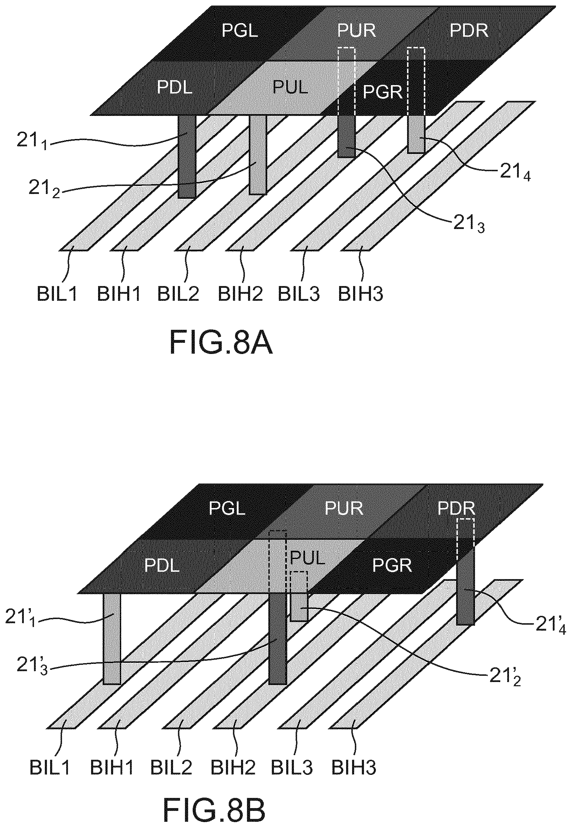

- les figures 8A-8B servent à illustrer différentes configurations de vias de connexions aux électrodes de polarisation arrière des transistors de cellules, ces configurations distinctes étant prévues en fonction d'états logiques respectifs que l'on souhaite imposer, lors d'une séquence d'initialisation et hors processus d'écriture conventionnel, à ces cellules mémoires distinctes ;

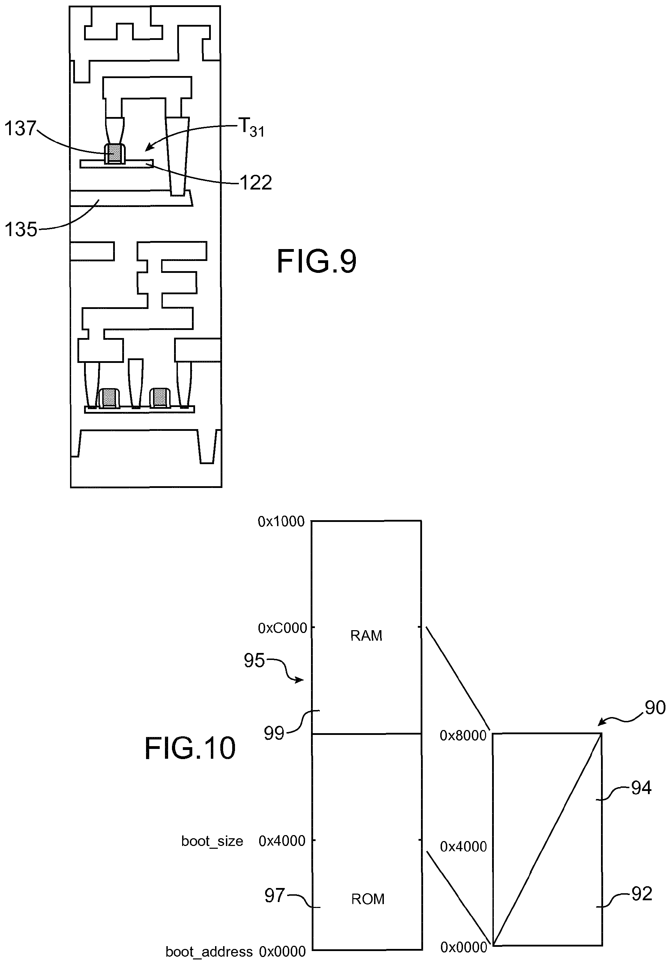

- la figure 9 sert à illustrer une configuration particulière de transistors d'accès avec une électrode de polarisation et une grille avant connectées entre elles ;
- la figure 10 sert à illustrer la correspondance entre un ensemble d'adresses virtuelles relatives à une mémoire RAM et une mémoire ROM, et une mémoire physique suivant un mode de réalisation particulier ;

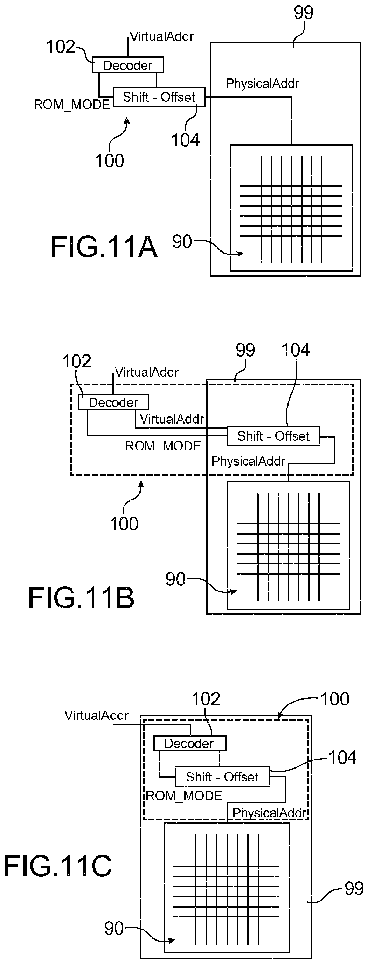

- les figures 11A-11C donnent différents exemples de réalisation d'un module de conversion d'adresse mémoire virtuelle en adresse physique ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

On se réfère à présent à la figure 1 illustrant un exemple d'agencement particulier de transistors T₂₁, T₂₂ dans une cellule mémoire appartenant à un dispositif microélectronique 3D mis en œuvre suivant un mode de réalisation de la présente invention et comportant plusieurs niveaux superposés de composants et d'interconnexions.

Les transistors T₂₁, T₂₂ sont en particulier des transistors respectivement d'un premier inverseur et d'un deuxième inverseur formant une bascule de cellule SRAM, typiquement des transistors de type N appelés transistors de conduction (ou « pull-up »), ou des transistors de type P appelés transistors de charge (ou « pull-down »).

Le dispositif est doté d'un premier niveau Ni comportant une première couche semi-conductrice 12 dans laquelle des composants électroniques sont au moins partiellement agencés. Dans l'exemple illustré donné sur la figure 1, ces composants sont des transistors dont les régions de canal respectives s'étendent dans la première couche semi-conductrice 12.

La première couche semi-conductrice 12 repose sur un substrat qui peut être de type semi-conducteur sur isolant tel qu'un substrat de type SOI (« Silicon On Insulator » ou « silicium sur isolant »), avantageusement selon une technologie de semi-conducteur sur isolant totalement déserté également appelée FDSOI (pour« Fully Depleted Silicon On Insulator »).

Dans ce cas, la première couche semi-conductrice superficielle 12 est disposée sur une couche isolante 11 communément appelée BOX (pour « Burried Oxide »), elle-même reposant sur une couche 10 de support semi-conductrice. Le premier niveau N₁ est ici également doté d'éléments d'interconnexions typiquement formés d'un ensemble de lignes métalliques 15a et de vias 15b disposés dans une couche isolante 17.

Le dispositif est pourvu d'au moins un deuxième niveau N₂ disposé sur le premier niveau Ni et comportant des transistors, en particulier les transistors T₂₁, T₂₂ dont les régions de canal respectives s'étendent dans au moins une deuxième couche semi-conductrice 22. Les transistors T₂₁, T₂₂, sont pourvus chacun d'une électrode de grille supérieure 37a, 37b agencée sur la deuxième couche semi-conductrice 22 et d'une électrode inférieure 35a, 35b située sous la deuxième couche semi-conductrice 22, autrement dit entre la deuxième couche semi-conductrice 22 et la première couche semi-conductrice 12.

L'électrode inférieure 35a, 35b est typiquement séparée de la deuxième couche semi-conductrice 22 par une couche de matériau diélectrique 34. Cette couche diélectrique 34 a une composition et une épaisseur prévues de sorte à permettre un couplage capacitif entre l'électrode inférieure 35 et la deuxième couche semi-conductrice 22. Ainsi, les régions de canal des transistors T₂₁,T₂₂, sont dans cet exemple également contrôlées par le dessous, respectivement par l'intermédiaire d'électrodes inférieures 35a, 35b qui, suivant les potentiels électriques qu'on leur applique, peuvent permettre de moduler la tension de seuil V_{T} des transistors T₂₁,T₂₂.

Les électrodes inférieures 35a, 35b sont connectées respectivement à une première ligne de polarisation et à une deuxième ligne de polarisation (non représentées sur la figure 1). Les lignes de polarisation sont typiquement sous forme de lignes métalliques amenées à véhiculer des signaux de polarisation des transistors T₂₁, T₂₂.

Dans l'exemple de réalisation particulier illustré sur la figure 2 (où les transistors PG_{L}, PU_{R}, PD_{R}, PD_{L}, PU_{L}, PG_{L} d'une première cellule Cᵢ SRAM à 6 transistors sont représentés de manière schématique par des zones rectangulaires), ce sont des transistors de conduction (pull-up) PU_{L}, PU_{R}, de la cellule SRAM qui ont une configuration du type de celle décrite précédemment et sont munis d'électrodes de polarisation arrière.

Les transistors PG_{L}, PU_{R}, PD_{R}, PD_{L}, PU_{L}, PG_{L} de la cellule sont situés dans un niveau supérieur Nₖ, tandis qu'une première ligne de polarisation BIL, et une deuxième ligne de polarisation BIH, respectivement connectées aux électrodes arrière 35a, 35b des transistors PU_{L}, PU_{R} sont situées dans un niveau inférieur Nₖ₋₁. La connexion entre les électrodes arrière 35a, 35b des transistors PU_{L}, PU_{R} et respectivement une première ligne de polarisation BIL et une deuxième ligne de polarisation BIH, est réalisée par l'intermédiaire de vias 21a, 21b.

L'agencement et la connexion des électrodes arrière 35a, 35b des transistors PU_{L}, PU_{R} vis-à-vis des lignes de polarisation BIL et BIH est pour la première cellule est tel qu'un premier via 21a connecte ici l'électrode arrière 35a du transistor PU_{L} à la première ligne de polarisation BIL, tandis qu'un deuxième via 21b connecte l'électrode arrière 35b du transistor PUR à la deuxième ligne de polarisation BIH. Les deux lignes de polarisation BIL, BIH, sont distinctes autrement dit non-connectées entre elles et peuvent être ainsi contrôlées indépendamment l'une de l'autre par le biais de signaux de polarisation distincts et qui peuvent être éventuellement différents l'un par rapport à l'autre.

Une telle configuration permet d'utiliser la cellule mémoire Cᵢ alternativement comme cellule de mémoire ROM et comme celui de cellule de mémoire RAM.

Les lignes de polarisation BIL et BIH permettent en particulier d'initialiser la première cellule Cᵢ et de lui imposer hors son mode de fonctionnement en SRAM conventionnel, et en particulier préalablement à ce mode de fonctionnement en SRAM, une donnée logique de pré-charge. La valeur de cette donnée logique d'initialisation dépend des signaux appliqués sur les lignes de polarisation BIL et BIH et pour un couple de signaux donné, de la manière dont la première cellule Cᵢ est connectée aux lignes de polarisation BIL et BIH. La valeur de cette donnée logique imposée lors de la séquence d'initialisation précitée peut être ainsi déterminée dès la conception du dispositif. La donnée logique imposée lors de la séquence d'initialisation constitue ainsi une donnée de mémoire ROM ou une donnée d'un code ROM que l'on peut déterminer lors de la conception du dispositif.

Sur la figure 3, une deuxième cellule Cₘ SRAM à 6 transistors appartenant au même ensemble de cellules, par exemple à une même rangée de cellules que la que celle Cᵢ décrite précédemment en lien avec la figure 2, est illustrée.

La cellule Cₘ est également connectée aux lignes de polarisation BIL et BIH qui permettent ainsi d'initialiser cette deuxième première cellule Cₘ, et de lui imposer, lors de la séquence d'initialisation précitée, une donnée logique de valeur complémentaire à celle de la première cellule.

Les électrodes arrière 35a, 35b respectives des transistors PU_{L}, PU_{R} sont donc également commandées à l'aide des mêmes lignes de polarisation BIL, BIH. La connexion entre les électrodes arrière 35a, 35b des transistors PU_{L}, PU_{R} et les lignes de polarisation BIL, BIH, est également réalisée par l'intermédiaire de vias 22a, 22b dont l'agencement diffère toutefois de celui prévu pour la première cellule Cᵢ.

Ainsi, pour la deuxième cellule Cₘ, un via 22a connecte cette fois l'électrode arrière 35a du transistor PU_{L} à la deuxième ligne de polarisation BIH, tandis qu'un deuxième via 22b connecte l'électrode arrière 35b du transistor PU_{R} à la première ligne de polarisation BIL.

Du fait de sa connexion différente (inverse) des électrodes arrières 35a, 35b, vis-à-vis des lignes de polarisation BIL et BIH, pour un même ensemble de signaux appliqués sur les lignes de polarisation BIL et BIH, la deuxième cellule Cₘ reçoit, sur ses électrodes arrière 35a, 35b respectives des transistors PU_{L}, PU_{R}, un couple de signaux inverse de celui reçu par la première cellule Cᵢ. La valeur de la donnée logique imposée lors de la séquence d'initialisation précitée peut être ainsi complémentaire de celle imposée à la première cellule Cᵢ.

Un exemple de séquence de signaux appliqués sur les lignes de polarisation BIL, BIH (non représentée sur la figure 2) et permettant de programmer les cellules qui leur sont connectées et d'utiliser ainsi, comme évoqué précédemment, ces cellules comme cellules d'une mémoire ROM, est donné sur le chronogramme de la figure 4.

Cette figure donne également l'évolution de la tension d'alimentation et en particulier du potentiel appliqué sur une ligne d'alimentation LVDD des inverseurs.

Au départ de la séquence (instant t0) d'initialisation, les inverseurs de la cellule ne reçoivent pas de tension d'alimentation. Autrement dit, la différence de potentiels entre une ligne d'alimentation LVDD connectée par exemple aux transistors de charge de la cellule et une ligne de masse connectée par exemple aux transistors de conduction de la cellule est maintenue nulle. Pour cela, on peut prévoir typiquement de placer la ligne d'alimentation LVDD à un potentiel VDDlow égal par exemple au potentiel de masse GND, tandis que la ligne de masse est mise également au même potentiel, par exemple au potentiel GND. La première ligne de polarisation BIL et ladite deuxième ligne de polarisation BIH sont quant à elles mises à un même potentiel nominal, par exemple VNBB, au départ de la séquence d'initialisation. Le potentiel nominal dépend du type de transistor N ou P que l'on connecte aux lignes de polarisation BIL, BIH. Dans le cas où les transistors sont de type NMOS on prévoit un potentiel nominal VNBB, par exemple choisi égal au potentiel de masse GND. Dans le cas où les transistors sont de type PMOS on prévoit un potentiel nominal VPBB qui peut être différent de VNBB.

Lors de cette première étape, une donnée mémorisée dans la cellule est alors détruite ou effacée, cet effacement étant effectué pour toutes les cellules reliées aux lignes LVDD, LGND, les nœuds de toutes les étant alors tous à la même valeur.

On applique alors (étape 1) un couple de potentiels respectivement sur ladite première ligne de polarisation BIL et ladite deuxième ligne de polarisation BIH, afin de mettre en œuvre une polarisation déséquilibrée des transistors de charge PU_{L}, PU_{R} l'un par rapport à l'autre. Un premier potentiel VBIL = VFBBp, est ainsi appliqué sur la première ligne de polarisation BIL, tandis qu'un deuxième potentiel VBIH = VRBBp différent du premier potentiel et dans cet exemple supérieur et qui peut être opposé au premier potentiel, est appliqué sur la deuxième ligne de polarisation BIL. L'application de ce couple de potentiels opposés VFBBp, VRBBp sur les lignes de polarisation BIL, BIH, entraine une polarisation dissymétrique, autrement dit déséquilibrée des inverseurs. Dans cet exemple de réalisation particulier, ce déséquilibre de polarisation est mis en œuvre en particulier sur les transistors de charge PU_{L}, PU_{R} de type P.

Le choix des potentiels VFBBp, VRBBp peut dépendre de variabilité de procédé de fabrication d'une cellule à l'autre dans une matrice mémoire, de variabilités temporelles. Le choix des potentiels VFBBp, VRBBp peut être également dicté par un critère de fiabilité en particulier de type 6σ (σ étant un écart type, le critère correspondant approximativement à 2 cellules défectueuses sur un milliard).

On applique ensuite (étape 2) un potentiel VDDhigh sur la ligne d'alimentation LVDD afin de rendre la différence de potentiels non-nulle entre la ligne d'alimentation LVDD et la ligne de masse LGND. Cette mise sous tension de l'alimentation ajoutée à la polarisation déséquilibrée des électrodes arrière se traduit au niveau des nœuds de mémorisation de la cellule par l'imposition d'une donnée logique, dont la valeur dépend de la manière dont la cellule est connectée aux lignes de polarisation BIL, BIH.

Ainsi, l'application d'un couple de potentiels VFBBp, VRBBp permet d'imposer un état logique donné, par exemple un '1' logique, à un nœud d'une première cellule. Pendant cette même séquence d'initialisation, une autre cellule, qui, de par sa connexion différente des transistors PU_{L}, PU_{R} respectivement aux lignes de polarisation BIH et BIL reçoit cette fois le couple inverse de potentiels VRBBp, VFBBp, et se voit alors imposer, un état logique complémentaire, par exemple un '0' logique à ce même nœud.

Autrement dit, une connexion donnée aux lignes de polarisation BIL et BIH, par exemple pour laquelle l'électrode arrière d'un premier transistor PU_{L}, est connectée à la ligne de polarisation BIH et pour laquelle l'électrode arrière d'un deuxième transistor PU_{R} est connectée à la ligne de polarisation BIL permet d'imposer un état logique complémentaire, par rapport à une configuration alternative dans laquelle l'électrode arrière du premier transistor PU_{L} est connectée à la ligne de polarisation BIL et l'électrode arrière du deuxième transistor PU_{R} est connectée à la ligne de polarisation BIH.

Ensuite (étape 3), on établit ou on rétablit un même potentiel nominal (VNBB pour des transistors de type N, VPBB pour des transistors de type P) sur les lignes de polarisation BIL et BIH, ce qui permet d'obtenir ou de rétablir un équilibre de polarisation ou une symétrie de polarisation entre les deux transistors de charge PU_{L}, PU_{R} de type P. Les potentiels appliqués permettent de conserver ainsi la donnée programmée et de rendre la cellule accessible en lecture et en écriture

Lors d'une première phase, la cellule a ainsi été initialisée ou programmée à une valeur de donnée de mémoire ROM ou de code ROM qui dépend de sa connexion aux lignes de polarisation BIL et BIH, cette valeur '1' ou '0' ayant été typiquement déterminée par le concepteur lors de la mise en œuvre du dispositif. Du fait du rééquilibrage de polarisation entre transistors PU_{L} et PU_{R} mis ensuite en œuvre lors d'une deuxième phase la séquence d'initialisation, on peut alors réutiliser cette cellule pré-chargée et la faire fonctionner comme une cellule SRAM conventionnelle accessible à la fois en lecture et en écriture.

En variante de l'exemple de réalisation qui vient d'être donné, on peut prévoir d'imposer une valeur de pré-charge lors de la séquence d'initialisation précitée, en mettant cette fois en œuvre un déséquilibre de polarisation entre les deux transistors de conduction PD_{L}, PD_{R}.

On peut également prévoir d'imposer une valeur de pré-charge lors de la séquence d'initialisation précitée, en mettant en œuvre un déséquilibre de polarisation entre les deux côtés de la cellule et réaliser en particulier un déséquilibre de polarisation à la fois entre les deux transistors de conduction PD_{L}, PD_{R} et les deux transistors de charge PU_{L}, PU_{R}.

Différents exemples de réalisation d'un circuit permettant d'appliquer une séquence de signaux afin d'effectuer une initialisation du type de celle décrite précédemment, sont donnés sur les figures 5 et 6.

Un premier exemple de réalisation particulier de circuit 40 illustré sur la figure 5 comprend des lignes de polarisation BIL et BIH et une partie permettant de réaliser une mise sous tension retardée de la ligne d'alimentation LVDD connectée aux deux inverseurs de la cellule. Un élément interrupteur commandé par un signal de commande CMD, est disposé entre une première portion 41 et la première ligne d'alimentation LVDD.

L'élément interrupteur est typiquement formé d'au moins un transistor 42 dont la grille reçoit un signal de commande CMD. Durant la première étape de la séquence d'initialisation, le signal de commande CMD se trouve dans un état de sorte que le transistor 42 est bloqué, la première portion 41 et la ligne d'alimentation LVDD n'étant alors pas connectés. Un changement d'état du signal de commande CMD permet de connecter la première portion 41 à la ligne d'alimentation LVDD, la ligne d'alimentation recevant une tension d'alimentation VDD.

Un deuxième exemple de circuit 50 est illustré sur la figure 6. Outre les lignes de polarisation BIL et BIH, ce circuit 50 comprend une portion 51 apte à recevoir la tension d'alimentation VDD. Une cellule à retard 52 est disposée entre la portion 51 et la ligne d'alimentation LVDD.

Un mode de réalisation particulier prévoit une cellule mémoire dotée de plus de deux transistors munis d'une électrode arrière reliée à une ligne de polarisation.

Dans l'exemple représenté sur la figure 7, la cellule SRAM a une structure de type communément appelée « 6T » avec 6 transistors, et notamment deux transistors de charge PU_{L}, PU_{R}, dans cet exemple de type PMOS, et deux transistors de conduction PD_{L}, PD_{R}, dans cet exemple de type NMOS, réalisant les deux inverseurs de la cellule.

Dans cet exemple de cellule, outre les deux transistors de charge PU_{L}, PU_{R}, munis chacun d'une électrode arrière resp. 35₁, 35₂, d'agencement semblable à celui décrit précédemment, deux transistors de conduction PD_{L}, PD_{R}, sont également munis d'électrodes arrière resp. 35₃, 35₄, permettant de moduler respectivement la tension de seuil du transistor de conduction PD_{L}, et de l'autre transistor de conduction PD_{R}. Deux transistors d'accès PG_{L}, PG_{R}, sont ici également munis d'électrodes arrière resp. 35₅, 35₆.

Cette cellule est également agencée dans un étage supérieur d'un dispositif microélectronique 3D comportant plusieurs étages superposés de transistors et est dotée, comme dans une structure de cellule SRAM conventionnelle, de deux nœuds de stockage Q_{L}, Q_{F}, prévus pour conserver une première information logique, et une deuxième information logique complémentaire de la première information. Le maintien des informations logiques dans les nœuds Q_{L}, Q_{F} est assuré par les transistors PU_{L}, PU_{R}, PD_{L}, PD_{R} formant les inverseurs bouclés sur eux-mêmes, c'est à dire montés en antiparallèle ou tête-bêche.

Ainsi, un premier inverseur est doté d'une entrée connectée au premier nœud Q_{L} de mémorisation et à une sortie d'un autre inverseur, le premier inverseur ayant en outre une sortie connectée au deuxième nœud Q_{F} et à une entrée de l'autre inverseur. Cet autre inverseur est donc doté d'une entrée connectée au deuxième nœud de stockage et d'une sortie connectée au premier nœud stockage.

Les transistors de charge PU_{L}, PU_{R} sont connectés à une ligne d'alimentation LVDD telle qu'évoquée précédemment et qui peut être elle-même reliée à l'un ou l'autre des circuits décrits précédemment en lien avec les figures 5 et 6 ou à un circuit permettant de mettre en œuvre une mise sous tension retardée de la ligne d'alimentation LVDD.

Les transistors d'accès PG_{L}, PG_{R} sont connectés respectivement à des lignes dites de bit BL_{L} et BL_{R} généralement partagées par les cellules SRAM d'une même colonne de cellules d'un plan matriciel formé de cellules agencées en lignes (rangées horizontales) et en colonnes (rangées verticales). L'accès aux nœuds de stockage Q_{L}, Q_{F} est commandé par une ligne de mot WL généralement partagée par des ou les cellules SRAM d'une même ligne (rangée horizontale) de cellules du plan matriciel. Les transistors d'accès PG_{L}, PG_{R} sont ainsi prévus pour permettre l'accès ou bloquer l'accès respectivement au premier nœud Q_{L}, et au deuxième nœud Q_{F}.

Différents cas de polarisation des électrodes arrière 35₁, 35₂, 35₃, 35₄, 35₅, 35₆ respectives des transistors PU_{L}, PU_{R}, PD_{L}, PD_{R}, PU_{L}, PU_{R} et permettant de réaliser une initialisation à un code de mémoire ROM telle que décrite précédemment sont donnés plus bas, à titre d'exemple, dans un tableau.

Dans ce tableau, VNBB et VPBB correspondent à des potentiels de polarisation par défaut susceptibles d'être appliqués durant la séquence d'initialisation à des électrodes arrière de transistors de type NMOS ou PMOS de la cellule qui sont distincts des transistors sur lesquels on applique le couple de polarisation directe VFBB, et de polarisation indirecte VRBB permettant, comme à l'étape 2 décrite précédemment, de créer le déséquilibre de polarisation afin d'imposer une donnée logique à la cellule lors de cette séquence.

Ces potentiels VNBB et VPBB peuvent être des potentiels standard habituellement utilisés par les concepteurs, et correspondre par exemple respectivement à une tension d'alimentation VDD et à un potentiel de masse GND ou inversement.

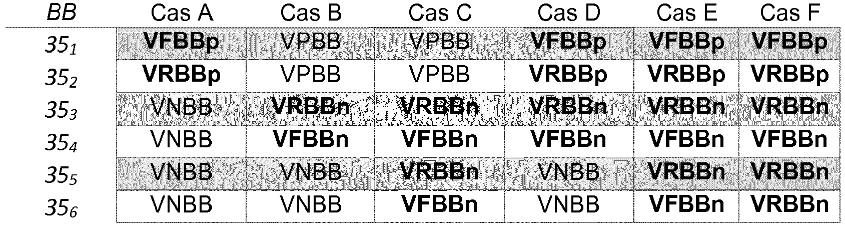

Dans un premier cas (cas A), les potentiels de polarisation directe VFBBp et de polarisation indirecte VRBBp, avec VFBBp < VPBB < VRBBp, VPBB étant un potentiel nominal sont appliqués respectivement sur l'électrode arrière d'un transistor de charge PU_{L}, et sur l'électrode arrière d'un autre transistor de charge PU_{R}, tous les deux de même type, ici de type PMOS, de manière à obtenir une polarisation déséquilibrée entre ces transistors de même type durant la deuxième étape de la séquence d'initialisation, tandis que les électrodes arrières des autres transistors, ici de type NMOS sont mises à un même potentiel nominal VNBB.

Dans ce premier cas, le déséquilibre de polarisation n'est réalisé que sur deux transistors. Seuls ces deux transistors font appel à une électrode arrière de polarisation.

Selon un deuxième cas (cas B), le déséquilibre de polarisation est mis en œuvre entre les deux transistors de conduction, les potentiels de polarisation directe VFBBn et de polarisation indirecte VRBBn, avec VRBBn < VNBB < VFBBn, VNBB étant un potentiel nominal étant appliqués respectivement sur l'électrode arrière d'un transistor de conduction PD_{L} de type NMOS, et sur l'autre électrode arrière d'un transistor de conduction PD_{R} de type NMOS.

Un troisième cas (cas C) prévoit un déséquilibre de polarisation d'un transistor de conduction PD_{L} de type NMOS par rapport à l'autre PD_{R} ainsi que d'un transistor d'accès PA_{L} de type NMOS par rapport à l'autre PA_{R}.

Dans un quatrième cas (cas D), le déséquilibre de polarisation est réalisé entre d'une part les transistors PD_{L}, PU_{L}, PA_{L} et d'autre part un autre côté de la cellule formé par les transistors PD_{R}, PU_{R}, PA_{R}. Selon un exemple de réalisation de ce quatrième cas, on prévoit par exemple d'appliquer les potentiels VFBBp = -2V et VRBBp= 2V respectivement sur l'électrode arrière d'un transistor de charge PU_{L}, et sur l'électrode arrière du transistor de charge PU_{R}, ici tous les deux de type PMOS. Dans cet exemple, on applique alors par exemple les potentiels VFBBn = 2V et VRBBn= -2V respectivement sur l'électrode arrière du transistor PD_{L}, et sur l'électrode arrière du transistor de conduction PD_{R}, ici tous les deux de type NMOS. Le potentiel nominal VNBB choisi peut être par exemple de 0V.

Un cinquième cas (cas E), le déséquilibre de polarisation est réalisé entre les transistors PD_{L}, PU_{L}, appartenant à un côté de la cellule et d'autre part les transistors PD_{R}, PU_{R},. appartenant à un autre côté de la cellule.

Un sixième cas (cas F), prévoit un déséquilibre de polarisation d'un inverseur par rapport à l'autre et une polarisation spécifique à un même potentiel VRBB des deux transistors d'accès pendant la première phase afin de réduire les courants de fuite.

Pour permettre la mise en œuvre d'une polarisation suivant l'un ou l'autre des cas exposés précédemment, on peut prévoir un agencement de la cellule tel que dans l'exemple d'agencement particulier illustré sur la figure 8A ou bien dans l'autre exemple de réalisation particulier illustré sur la figure 8B.

Les transistors PU_{L}, PU_{R}, PD_{L}, PD_{R}, PU_{L}, PU_{R} sont situés dans un niveau donné Nₖ d'un dispositif comportant plusieurs niveaux de composants avec des lignes de polarisation BIL₁, BIH₁, BIL₂, BIH₂, BIL₃, BIH₃ aptes à acheminer les différents potentiels de polarisation aux électrodes arrière des transistors de la cellules situées sous ce niveau Nₖ.

Si l'on se place dans le cas D de polarisation du tableau donné ci-dessus, Les lignes de polarisation BIL₁ et BIL₃ peuvent être en particulier celles prévues pour acheminer un potentiel indirect VRBBn, tandis que la ligne de polarisation BIL₂ achemine un potentiel indirect VRBBp. Les lignes de polarisation BIH₁ et BIH₃, peuvent être en particulier prévues pour acheminer un potentiel direct VFBBn, tandis que la ligne de polarisation BIL₂ achemine un potentiel direct VFBBp.

La manière dont les électrodes arrière (non représentées sur ces figures) des transistors PU_{L}, PU_{R}, PD_{L}, PD_{R}, PU_{L}, PU_{R} sont connectées aux différentes lignes de polarisation détermine l'information logique imposée à la cellule lors de la séquence de d'initialisation.

Par exemple, sur la figure 8A, les électrodes arrière des transistors PD_{L}, PU_{R}, sont connectées, par l'intermédiaire de vias 21₁, 21₃ conducteurs respectivement aux lignes de polarisation BIH₁, BIH₂ aptes à acheminer respectivement le potentiel de polarisation direct VFBBn, et le potentiel de polarisation direct VFBBp en particulier pendant la deuxième étape de la séquence d'initialisation. Les électrodes arrière des transistors PU_{L}, PD_{R}, sont quant à elles connectées, par l'intermédiaire de vias 21₂, 21₄ conducteurs respectivement aux lignes de polarisation BIL₂, BIL₃ aptes à acheminer respectivement, lors de cette même deuxième étape, le potentiel de polarisation indirect VRBBp (avec VRBBp > VFBBp) et le potentiel VRBBn (avec VRBBn < VFBBn). Dans ce cas, le premier nœud Q_{L} peut être par exemple amené à stocker une information logique ou un niveau logique '1'.

Sur la figure 8B, correspondant au cas de polarisation D évoqué plus haut, les électrodes arrière des transistors PD_{L}, PU_{R}, d'une autre cellule sont cette fois connectées, par l'intermédiaire de vias 21'₁, 21'₃ conducteurs respectivement aux lignes de polarisation BIL₁, BIL₂ aptes à acheminer respectivement un potentiel indirect VRBBn et un potentiel indirect VRBBp, en particulier pendant la deuxième étape de la séquence d'initialisation. Les électrodes arrière des transistors PU_{L}, PD_{R}, sont quant à elles connectées, par l'intermédiaire de vias 21'₂, 21'ₐ conducteurs respectivement aux lignes de polarisation BIH₂, BIH₃ aptes à acheminer respectivement un potentiel de polarisation direct VFBBp (avec VFBBp < VRBBp), et un potentiel de polarisation direct VFBBn (avec VFBBn > VRBBn). Dans ce cas, le premier nœud Q_{L} de cette autre cellule peut être par exemple amené à stocker une un niveau logique '0'.

Afin de réduire le nombre de lignes de polarisation, on peut prévoir, en variante des exemples de réalisation des figures 8A-8B, de mettre en œuvre une ligne de polarisation commune entre l'électrode arrière d'un transistor d'accès PG_{L} et celle d'un transistor de conduction PD_{L} voisin, ainsi qu'une ligne de polarisation commune entre l'électrode arrière de l'autre transistor d'accès PG_{R} et celle de l'autre transistor de conduction PD_{L}. Une telle configuration peut permettre en particulier de réaliser les cas C et E de polarisation donnés précédemment durant la première phase de fonctionnement.

Une autre variante prévoit de relier l'électrode arrière des transistors d'accès PG_{L}, PG_{R} à un nœud ou à une ligne dédiée à l'application d'un potentiel VRBB, en particulier durant une première phase de la séquence d'initialisation. Une telle variante de configuration peut permettre de mettre en œuvre le cas F de polarisation donné précédemment.

Afin de réduire le nombre de lignes de polarisation, on peut également prévoir des transistors d'accès ayant un agencement reprenant celui illustré sur la figure 9, avec une électrode arrière 135 couplée, comme dans l'exemple de la figure 1, par couplage capacitif à une région de canal 122, et connectée cette fois à son électrode de grille 137 située sur la région de canal 122.

La figure 10 représente de manière schématique une mémoire physique 90 qui comporte un secteur 92 susceptibles de réaliser une mémoire RAM et une mémoire ROM. Le secteur 92 est ainsi formé d'un ensemble de cellules ayant un agencement et une polarisation tels que décrits précédemment, en particulier en lien avec les figures 1 à 8.

Le bloc 95 représente un ensemble d'adresses virtuelles vues d'un processeur ou d'une unité centrale de traitement, (en anglais CPU pour « central processing unit ») amené à exploiter des données de la mémoire physique 90 et appartenant à un système de traitement numérique.

Le processeur peut être amené, lors d'un premier accès mémoire, correspondant par exemple à une phase d'initialisation du système, à exploiter ou lire des données de programme, en particulier d'un programme d'amorçage (BOOT selon la terminologie anglo-saxonne) stockées dans la partie ROM de la mémoire physique 90 et correspondant à des cellules du secteur 92 auxquelles on a appliqué la séquence d'initialisation décrite précédemment.

Le processeur peut être amené ensuite, lors d'un deuxième accès mémoire, à exploiter des données de mémoire RAM, correspondant aux mêmes cellules du secteur 92 maintenues suivant une polarisation équilibrée des lignes de polarisation des électrodes arrière.

Une différenciation entre un accès à la mémoire ROM et un accès à la mémoire RAM peut être réalisé par décodage d'adresse virtuelle lors de la réception d'une requête d'accès en lecture/écriture. Cette différenciation entre accès à la mémoire ROM et accès à la mémoire RAM est opéré à l'aide d'un module de gestion d'adresses virtuelles permettant de convertir une adresse virtuelle en adresse physique.

Différents exemples de mise en œuvre d'un module 100 de conversion d'adresse virtuelle en adresse physique sont donnés sur les figures 11A-11C.

Ces figures servent à illustrer respectivement :
- un premier cas dans lequel le module 100 est entièrement dissocié d'un support 99 sur lequel se trouve la mémoire physique 90,
- un deuxième cas dans lequel le module 100 est partiellement situé sur le support 99 de la mémoire physique 90,
- un troisième cas dans lequel le module 100 est entièrement intégré sur le même support 99 que la mémoire physique 90.

Dans le deuxième cas, le support 99 de mémoire peut comprendre une broche spécifique pour recevoir un signal ROM_MODE indicateur d'un type d'accès mémoire réalisé sur la mémoire physique entre un accès à des cellules lorsqu'elles contiennent chacune une donnée pré-chargée lors de la phase d'initialisation ou à des cellules qui se trouvent dans leur mode de fonctionnement conventionnel et sont accessibles en lecture et écriture.

Dans le troisième cas, le support 99 sur lequel se trouve la mémoire peut comprendre un décodeur 102, ce décodeur 102 disposant alors typiquement d'informations de mappage liées à la mémoire virtuelle 95 vue du processeur.

Dans les trois cas, le module 100 est doté d'un décodeur 102 configuré pour à partir d'une adresse virtuelle « VirtuelAddr » émettre un signal indicateur ROM_MOD de type d'accès mémoire entre un accès relatif à la mémoire ROM et un accès relatif à la mémoire RAM. Ce signal indicateur est différent suivant qu'un accès à la mémoire ROM ou à la mémoire RAM est requis. Le décodeur 102 peut se servir pour cela d'une donnée « boot_size » liée à la taille de l'espace réservé à la mémoire ROM 97.

Le décodeur 102 est configuré pour transmettre le signal indicateur de type d'accès mémoire et transmettre l'adresse virtuelle à un module de décalage 104 chargé d'appliquer une opération dite de « décalage » à l'adresse virtuelle et produire en conséquence une adresse physique « PhysicalAddr » résultant de cette opération.

Un dispositif mémoire tel que décrit précédemment peut être utilisé typiquement dans un système numérique, comportant un processeur, par exemple un processeur graphique ou GPU (pour « Graphics Processing Unit ») ou un processeur de signal numérique (DSP pour « Digital Signal Processor ») se servant des données d'une mémoire ROM pour son initialisation. Une fois ces données utilisées, les cellules sont reconfigurées (polarisation en mode mémoire SRAM standard) et peuvent être ainsi réutilisées.

Une application particulière d'un dispositif mémoire tel que décrit précédemment prévoit que l'information logique stockée par un ensemble de cellules lorsqu'elles fonctionnent en mode ROM peut constituer une information d'identification de circuit et en particulier une information de type PUF (pour « Physical Unclonable Function ») autrement dit un identifiant unique d'un dispositif électronique.

Ainsi, un procédé d'identification de circuit dans lequel on vient lire un code correspondant aux données de mémoire ROM pré-chargées consécutivement à une séquence d'initialisation telle que décrite précédemment, et qui dépend pour chaque cellule de son agencement par rapport aux lignes de polarisation BIL et BIH peut être prévu.

Bien que l'invention s'applique avantageusement à une cellule mémoire 6T, c'est-à-dire à 6 transistors, l'invention s'applique également à des cellules mémoires comportant moins de 6 transistors, par exemple 4 transistors. Dans ce cas, chaque cellule mémoire peut comporter 2 transistors NMOS et 2 transistors d'accès, et la polarisation arrière différentiée, c'est-à-dire le déséquilibre, s'applique de préférence aux transistors d'accès qui jouent le rôle de transistors de « pull-up » ou charge. L'invention peut s'appliquer également à des cellules mémoires comportant plus de 6 transistors, par exemple 8 ou 10 transistors.

En outre, lorsque l'invention s'applique à des cellules 6T, la polarisation arrière différentiée peut s'appliquer seulement aux deux transistors de type N ou aux deux transistors de type P formant les inverseurs. L'effet est plus significatif lorsque le déséquilibre est appliqué sur les transistors formant les inverseurs de la cellule mémoire plutôt que sur les transistors d'accès.

Enfin, l'expression « ligne de polarisation » désigne ici une ligne électriquement conductrice destinée à l'application d'un potentiel électrique de polarisation. Elles servent notamment à appliquer un potentiel de polarisation sur les électrodes arrières des transistors. Il convient de noter que les lignes de polarisation peuvent être utilisées dans des phase de fonctionnement des cellules mémoires autres que la phase d'initialisation, par exemple pendant la phase de « stand-by » ou d'attente.

## Revendications

1. Dispositif microélectronique doté de plusieurs niveaux (N₁, N₂) superposés de composants et comportant :
- un niveau inférieur (N₁) doté d'un ou plusieurs composants (T₁₁) formés dans au moins une première couche semi-conductrice,
- un niveau supérieur (N₂) comprenant des transistors (T₂₁,T₂₂) ayant des régions de canal respectives formées dans au moins une deuxième couche semi-conductrice (22) disposée au-dessus de la première couche semi-conductrice (12), le dispositif comprenant :
- un ensemble de cellules mémoires dotées chacune d'un premier inverseur et d'un deuxième inverseur connectés de façon croisée, le premier inverseur et le deuxième inverseur étant connectés à, et agencés entre, une ligne d'alimentation (LVDD) d'alimentation et une ligne de masse (LGND),
le premier inverseur et le deuxième inverseur comprenant respectivement au moins un premier transistor (T₂₁) d'un premier type, N ou P, et au moins un deuxième transistor (T₂₂) du premier type N ou P, appartenant audit niveau supérieur et ayant chacun une électrode inférieure (35a, 35b) située entre la deuxième couche semi-conductrice (22) et la première couche semi-conductrice (12) et couplée par couplage capacitif avec une région de canal située dans la deuxième couche semi-conductrice (22),
lesdites cellules dudit ensemble étant connectées en outre à :
- une première ligne (BIL, BIL2, BIL1) de polarisation de l'une parmi l'électrode inférieure (35a) du premier transistor et l'électrode inférieure (35b) du deuxième transistor,
- une deuxième ligne (BIH, BIH2, BIH1) de polarisation de l'autre parmi l'électrode inférieure (35a) du premier transistor et l'électrode inférieure (35b) du deuxième transistor,
le dispositif comprenant en outre un circuit (40, 50) configuré pour lors d'une séquence d'initialisation :
- pendant une première phase appliquer un premier potentiel (VFBB, VRBB) et un deuxième potentiel (VRBB, VFBB) différent du premier potentiel, respectivement sur ladite première ligne de polarisation et ladite deuxième ligne de polarisation, et appliquer une tension entre ladite ligne d'alimentation (LVDD) et la ligne de masse, de sorte à imposer à chaque cellule dudit ensemble une donnée logique dont la valeur dépend de la ligne de polarisation parmi lesdites lignes de polarisation à laquelle l'électrode inférieure de son premier transistor et l'électrode inférieure de son deuxième transistor sont respectivement connectées,
puis
- pendant une deuxième phase appliquer un même potentiel nominal (VNBB, VPBB) sur la première ligne de polarisation (BIL) et la deuxième ligne de polarisation (BIH), et maintenir une tension entre ladite ligne d'alimentation (LVDD) et la ligne de masse (LGND), de sorte à conserver cette donnée logique et rendre les cellules dudit ensemble accessibles en lecture et en écriture,
une première cellule dudit ensemble étant connectée aux premières ligne de polarisation (BIL) et deuxième ligne de polarisation par l'intermédiaire d'une paire de vias (22a, 22b), une deuxième cellule dudit ensemble et appartenant à une même rangée de cellules que ladite première cellule étant connectée aux première ligne de polarisation (BIL) et deuxième ligne de polarisation par l'intermédiaire d'une autre paire de vias (22a, 22b).

2. Dispositif microélectronique selon la revendication 1, dans lequel au moins une première cellule dudit ensemble a une électrode inférieure de son premier transistor (T₂₁) qui est connectée à la première ligne (BIL) de polarisation et une électrode inférieure (35b) du deuxième transistor qui est connectée à la deuxième ligne (BIH) de polarisation, au moins une deuxième cellule dudit ensemble ayant une électrode inférieure de son premier transistor (T₂₁) qui est connectée à la deuxième ligne (BIH) de polarisation et une électrode inférieure (35b) de son deuxième transistor qui est connectée à la première ligne (BIL) de polarisation, de sorte que lors de ladite séquence d'initialisation, une première donnée logique est imposée à la première cellule, et une deuxième donnée logique, complémentaire de la première donnée est imposée à la deuxième cellule.

3. Dispositif microélectronique selon l'une des revendications 1 ou 2, dans lequel les cellules dudit ensemble comprennent respectivement au moins un troisième transistor et au moins un quatrième transistor, le troisième transistor et le quatrième transistor étant d'un deuxième type, P ou N, opposé au premier type, le troisième transistor et le quatrième transistor appartenant audit niveau supérieur et ayant chacun une électrode inférieure (35a, 35b) située entre la deuxième couche semi-conductrice et la première couche semi-conductrice et couplée par couplage capacitif avec une région de canal située dans la deuxième couche semi-conductrice (22), lesdites cellules dudit ensemble étant connectées en outre à :
- au moins une troisième ligne (BIL) de polarisation de l'une parmi l'électrode inférieure du troisième transistor et l'électrode inférieure du quatrième transistor,
- au moins une quatrième ligne de polarisation de l'autre parmi l'électrode inférieure du troisième transistor et l'électrode inférieure du quatrième transistor.

4. Dispositif microélectronique selon la revendication 3, ledit circuit (40, 50) étant configuré pour lors de ladite première phase de la séquence d'initialisation :
- appliquer un couple de potentiels différents (VFBB, VRBB), respectivement sur ladite troisième ligne de polarisation et ladite quatrième ligne de polarisation, puis
- lors de la deuxième phase appliquer un même potentiel nominal (VNBB, VPBB) sur la troisième ligne de polarisation (BIL) et la quatrième ligne de polarisation (BIH).

5. Dispositif microélectronique selon l'une des revendications 1 à 3, dans lequel le premier transistor (T₂₁) et le deuxième transistor (T₂₂), sont :
- respectivement, un premier transistor de charge (PU_{L}) et un deuxième transistor de charge (PU_{R}) de type P,
ou
- respectivement, un premier transistor de conduction (PD_{L}) et un deuxième transistor de conduction (PD_{R}) de type N.

6. Dispositif microélectronique selon la revendication 5, dans lequel le premier transistor (T₂₁) et le deuxième transistor (T₂₂) sont respectivement, un premier transistor de charge (PU_{L}) et un deuxième transistor de charge (PU_{R}) de type P, les cellules dudit ensemble étant chacune dotées d'un premier transistor de conduction (PD_{L}) ayant une grille connectée à une grille du premier transistor de charge (PU_{L}) et d'un deuxième transistor de conduction (PD_{R}) ayant une grille connectée à une grille du deuxième transistor de charge (PU_{R}), les transistors de conduction (PD_{L}, PD_{R}) étant munis d'une électrode inférieure couplée par couplage capacitif avec une région de canal,
les électrodes inférieures respectivement dudit premier transistor de conduction (PD_{L}) et dudit deuxième transistor de conduction (PD_{R}) étant mises à un même potentiel (VNBB) durant la première phase de la séquence d'initialisation ou étant mises respectivement à un troisième potentiel (VRBBn) et à un quatrième potentiel (VFBBn),
ou dans lequel le premier transistor (T₂₁) et le deuxième transistor (T₂₂) sont respectivement, un premier transistor de conduction (PD_{L}) et un deuxième transistor de conduction (PD_{R}) de type N, les cellules dudit ensemble étant chacune dotées d'un premier transistor de charge (PU_{L}) ayant une grille connectée à une grille du premier transistor de conduction (PD_{L}) et d'un deuxième transistor de charge (PU_{R}) ayant une grille connectée à une grille du deuxième transistor de conduction (PD_{R}), les transistors de conduction (PD_{L}, PD_{R}) étant munis d'une électrode inférieure couplée par couplage capacitif avec une région de canal,
les électrodes inférieures respectivement dudit premier transistor de charge (PU_{L}) et dudit deuxième transistor de charge (PU_{R}) étant durant la première phase de la séquence d'initialisation : mises à un même potentiel (VPBB) ou étant mises respectivement à un troisième potentiel (VFBBp) et à un quatrième potentiel potentiel (VRBBp).

7. Dispositif microélectronique selon la revendication 6, dans lequel lesdites cellules dudit ensemble sont dotées en outre d'un premier transistor d'accès (PG_{L}) au premier nœud et d'un deuxième transistor d'accès (PG_{R}) au deuxième nœud, le premier transistor d'accès et le deuxième transistor d'accès étant dotés chacun d'une électrode inférieure située entre la deuxième couche semi-conductrice et la première couche semi-conductrice et couplée par couplage capacitif avec une région de canal située dans la deuxième couche semi-conductrice (22).

8. Dispositif microélectronique selon la revendication 7, dans lequel les transistors d'accès sont de même type que le premier transistor et le deuxième transistor, les électrodes inférieures respectivement dudit premier transistor d'accès (PA_{L}) et dudit deuxième transistor d'accès (PA_{R}) étant durant la première phase de la séquence d'initialisation : mises à un même potentiel (VNBB, VRBBn) ou étant mises respectivement au premier potentiel (VFBBn) et au deuxième potentiel (VRBBn).

9. Dispositif microélectronique selon l'une des revendications 1 à 8, dans lequel ledit circuit (40) comprend : un élément interrupteur (42) entre une portion (41) apte à recevoir une tension d'alimentation VDD et la ligne d'alimentation (LVDD), l'élément interrupteur étant configuré pour alternativement déconnecter puis connecter la portion (41) à la ligne d'alimentation (LVDD1) suite à un changement d'état d'un premier signal de commande (CMD).

10. Dispositif microélectronique selon l'une des revendications 1 à 9, dans lequel ledit circuit (60) comprend : une portion (51) recevant une tension d'alimentation VDD, au moins une cellule à retard (52) étant disposée entre ladite portion (51) et ladite ligne d'alimentation (LVDD).

11. Dispositif microélectronique selon l'une des revendications 1 à 10, dans lequel ledit ensemble de cellules mémoire appartient à un dispositif mémoire comprenant en outre un module de conversion d'adresse mémoire virtuelle en adresse mémoire physique, ledit module de conversion (100) étant doté d'un décodeur (102) configuré pour : à partir d'une adresse virtuelle, produire un signal indicateur (ROM_MODE) d'un premier type d'accès mémoire à des données pré-chargées dans ledit ensemble de cellules lors de ladite séquence d'initialisation ou un signal indicateur d'un deuxième type d'accès mémoire à des données écrites dans ledit ensemble de cellules après ladite séquence d'initialisation et transmettre cette adresse virtuelle à un module de décalage, le module de décalage (104) étant configuré pour appliquer une opération de décalage à une adresse virtuelle afin de produire une adresse physique.

## Patentansprüche

1. Mikroelektronische Vorrichtung, die mit mehreren einander überlagerten Niveaus (N₁, N₂) von Komponenten ausgestattet ist und Folgendes umfasst:
- ein unteres Niveau (N₁), das mit einer oder mehreren Komponenten (T₁₁) ausgestattet ist, die in wenigstens einer ersten Halbleiterschicht gebildet sind,
- ein oberes Niveau (N₂), das Transistoren (T₂₁, T₂₂) umfasst, die jeweilige Kanalregionen haben, die in wenigstens einer zweiten Halbleiterschicht (22) gebildet sind, die über der ersten Halbleiterschicht (12) angeordnet ist, wobei die Vorrichtung umfasst:
- eine Gruppe von Speicherzellen, die jeweils mit einem ersten Inverter und mit einem zweiten Inverter ausgestattet sind, die in gekreuzter Weise verbunden sind, wobei der erste Inverter und der zweite Inverter mit einer Versorgungsleitung (LVDD) zur Versorgung und einer Masseleitung (LGND) verbunden und dazwischen angeordnet sind,
wobei der erste Inverter und der zweite Inverter wenigstens einen ersten Transistor (T₂₁) eines ersten Typs, N oder P, beziehungsweise wenigstens einen zweiten Transistor (T₂₂) des ersten Typs N oder P umfassen, die zu dem oberen Niveau gehören und jeweils eine untere Elektrode (35a, 35b) haben, die zwischen der zweiten Halbleiterschicht (22) und der ersten Halbleiterschicht (12) angeordnet und mittels kapazitiver Kopplung mit einer Kanalregion gekoppelt ist, die in der zweiten Halbleiterschicht (22) angeordnet ist,
wobei die Zellen der Gruppe ferner verbunden sind mit:
- einer ersten Leitung (BIL, BIL2, BIL1) zur Polarisation der einen von der unteren Elektrode (35a) des ersten Transistors und der unteren Elektrode (35b) des zweiten Transistors,
- einer zweiten Leitung (BIH, BIH2, BIH1) zur Polarisation der anderen von der unteren Elektrode (35a) des ersten Transistors und der unteren Elektrode (35b) des zweiten Transistors,
wobei die Vorrichtung ferner eine Schaltung (40, 50) umfasst, die zu Folgendem während einer Initialisierungssequenz konfiguriert ist:
- während einer ersten Phase, Anlegen eines ersten Potenzials (VFBB, VRBB) und eines von dem ersten Potenzial verschiedenen zweiten Potenzials (VRBB, VFBB) an die erste Polarisationsleitung beziehungsweise die zweite Polarisationsleitung, und Anlegen einer Spannung zwischen der Versorgungsleitung (LVDD) und der Masseleitung derart, dass jeder Zelle der Gruppe ein logisches Datenelement auferlegt wird, dessen Wert von der Polarisationsleitung aus den Polarisationsleitungen abhängt, mit der die untere Elektrode ihres ersten Transistors und die untere Elektrode ihres zweiten Transistors jeweils verbunden sind,
dann
- während einer zweiten Phase, Anlegen ein und desselben nominalen Potenzials (VNBB, VPBB) an die erste Polarisationsleitung (BIL) und die zweite Polarisationsleitung (BIH), und Halten einer Spannung zwischen der Versorgungsleitung (LVDD) und der Masseleitung (LGND) derart, dass dieses logische Datenelement bewahrt wird und die Zellen der Gruppe zum Lesen und zum Schreiben zugänglich werden,
wobei eine erste Zelle der Gruppe mit der ersten Polarisationsleitung (BIL) und der zweiten Polarisationsleitung mittels eines Paars von Durchführungen (22a, 22b) verbunden ist, wobei eine zweite Zelle der Gruppe, die zu ein und derselben Reihe von Zellen gehört wie die erste Zelle mit der ersten Polarisationsleitung (BIL) und der zweiten Polarisationsleitung mittels eines anderen Paars von Durchführungen (22a, 22b) verbunden ist.

2. Mikroelektronische Vorrichtung nach Anspruch 1, bei der wenigstens eine erste Zelle der Gruppe eine untere Elektrode ihres ersten Transistors (T₂₁) hat, die mit der ersten Polarisationsleitung (BIL) verbunden ist, und eine untere Elektrode (35b) des zweiten Transistors, die mit der zweiten Polarisationsleitung (BIH) verbunden ist, wobei wenigstens eine zweite Zelle der Gruppe eine untere Elektrode ihres ersten Transistors (T₂₁) hat, die mit der zweiten Polarisationsleitung (BIH) verbunden ist, und eine untere Elektrode (35b) ihres zweiten Transistors, die mit der ersten Polarisationsleitung (BIL) verbunden ist, derart, dass während der Initialisierungssequenz ein erstes logisches Datenelement der ersten Zelle auferlegt wird, und ein zweites logisches Datenelement, das zu dem ersten Datenelement komplementär ist, der zweiten Zelle auferlegt wird.

3. Mikroelektronische Vorrichtung nach einem der Ansprüche 1 oder 2, bei der die Zellen der Gruppe jeweils wenigstens einen dritten Transistor und wenigstens einen vierten Transistor umfassen, wobei der dritte Transistor und der vierte Transistor von einem zweiten Typ, P oder N, entgegengesetzt zu dem ersten Typ sind, wobei der dritte Transistor und der vierte Transistor zu dem oberen Niveau gehören und jeweils eine untere Elektrode (35a, 35b) haben, die zwischen der zweiten Halbleiterschicht und der ersten Halbleiterschicht angeordnet und mittels kapazitiver Kopplung mit einer Kanalregion gekoppelt ist, die in der zweiten Halbleiterschicht (22) angeordnet ist, wobei die Zellen der Gruppe ferner verbunden sind mit:
- wenigstens einer dritten Leitung (BIL) zur Polarisation der einen aus der unteren Elektrode des dritten Transistors und der unteren Elektrode des vierten Transistors,
- wenigstens einer vierten Leitung zur Polarisation der anderen aus der unteren Elektrode des dritten Transistors und der unteren Elektrode des vierten Transistors.

4. Mikroelektronische Vorrichtung nach Anspruch 3, wobei die Schaltung (40, 50) zu Folgendem während der ersten Phase der Initialisierungssequenz konfiguriert ist:
- Anlegen eines Paars von verschiedenen Potenzialen (VFBB, VRBB) an die dritte Polarisationsleitung beziehungsweise die vierte Polarisationsleitung, dann
- während der zweiten Phase, Anlegen ein und desselben nominalen Potenzials (VNBB, VPBB) an die dritte Polarisationsleitung (BIL) und die vierte Polarisationsleitung (BIH).

5. Mikroelektronische Vorrichtung nach einem der Ansprüche 1 bis 3, bei der der erste Transistor (T₂₁) und der zweite Transistor (T₂₂) Folgendes sind:
- ein erster Ladungstransistor (PU_{L}) beziehungsweise ein zweiter Ladungstransistor (PU_{R}) vom Typ P,
oder
- ein erster Leitungstransistor (PD_{L}) beziehungsweise ein zweiter Leitungstransistor (PD_{R}) vom Typ N.

6. Mikroelektronische Vorrichtung nach Anspruch 5, bei der der erste Transistor (T₂₁) und der zweite Transistor (T₂₂) ein erster Ladungstransistor (PU_{L}) beziehungsweise ein zweiter Ladungstransistor (PU_{R}) vom Typ P sind, wobei die Zellen der Gruppe jeweils ausgestattet mit einem ersten Leitungstransistor (PD_{L}) mit einem Gate, das mit einem Gate des ersten Ladungstransistors (PU_{L}) verbunden ist, und mit einem zweiten Leitungstransistor (PD_{R}) mit einem Gate, das mit einem Gate des zweiten Ladungstransistors (PU_{R}) verbunden ist, wobei die Leitungstransistoren (PD_{L}, PD_{R}) mit einer unteren Elektrode versehen sind, die mittels kapazitiver Kopplung mit einer Kanalregion gekoppelt ist,
wobei die unteren Elektroden des ersten Leitungstransistors (PD_{L}) beziehungsweise des zweiten Leitungstransistors (PD_{R}) während der ersten Phase der Initialisierungssequenz auf ein und dasselbe Potenzial (VNBB) gebracht sind oder auf ein drittes Potenzial (VRBBn) beziehungsweise ein viertes Potenzial (VFBBn) gesetzt sind,
oder bei der der erste Transistor (T₂₁) und der zweite Transistor (T₂₂) ein erster Leitungstransistor (PD_{L}) beziehungsweise ein zweiter Leitungstransistor (PD_{R}) vom Typ N sind, wobei die Zellen der Gruppe jeweils mit einem ersten Ladungstransistor (PU_{L}) mit einem Gate ausgestattet sind, das mit einem Gate des ersten Leitungstransistors (PD_{L}) verbunden ist, und mit einem zweiten Ladungstransistor (PU_{R}) mit einem Gate, das mit einem Gate des zweiten Leitungstransistors (PD_{R}) verbunden ist, wobei die Leitungstransistoren (PD_{L}, PD_{R}) mit einer unteren Elektrode versehen sind, die mittels kapazitiver Kopplung mit einer Kanalregion gekoppelt ist,
wobei die unteren Elektroden des ersten Ladungstransistors (PU_{L}) beziehungsweise des zweiten Ladungstransistors (PU_{R}) während der ersten Phase der Initialisierungssequenz Folgendes sind: auf ein und dasselbe Potenzial (VPBB) gesetzt, oder auf ein drittes Potenzial (VFBBp) beziehungsweise auf ein viertes Potenzial (VRBBp) gesetzt.

7. Mikroelektronische Vorrichtung nach Anspruch 6, bei der die Zellen der Gruppe ferner mit einem ersten Zugriffstransistor (PG_{L}) für den ersten Knoten und einem zweiten Zugriffstransistor (PG_{R}) für den zweiten Knoten ausgestattet sind, wobei der erste Zugriffstransistor und der zweite Zugriffstransistor jeweils ausgestattet sind mit einer unteren Elektrode, die zwischen der zweiten Halbleiterschicht und der ersten Halbleiterschicht angeordnet und mittels kapazitiver Kopplung mit einer Kanalregion gekoppelt ist, die in der zweiten Halbleiterschicht (22) angeordnet ist.

8. Mikroelektronische Vorrichtung nach Anspruch 7, bei der die Zugriffstransistoren vom gleichen Typ wie der erste Transistor und der zweite Transistor sind, wobei die unteren Elektroden des ersten Zugriffstransistors (PA_{L}) beziehungsweise des zweiten Zugriffstransistors (PA_{R}) während der ersten Phase der Initialisierungssequenz Folgendes sind: auf ein und dasselbe Potenzial (VNBB, VRBBn) gesetzt, oder auf das erste Potenzial (VFBBn) beziehungsweise auf das zweite Potenzial (VRBBn) gesetzt.

9. Mikroelektronische Vorrichtung nach einem der Ansprüche 1 bis 8, bei der die Schaltung (40) umfasst: ein Unterbrecherelement (42) zwischen einem Bereich (41), der dazu ausgelegt ist, eine Versorgungsspannung VDD zu empfangen, und der Versorgungsleitung (LVDD), wobei das Unterbrecherelement dazu konfiguriert ist, in Folge einer Zustandsänderung eines ersten Steuersignals (CMD) den Bereich (41) von der Versorgungsleitung (LVDD1) alternativ zu trennen und dann zu verbinden.

10. Mikroelektronische Vorrichtung nach einem der Ansprüche 1 bis 9, bei der die Schaltung (60) umfasst: einen Bereich (51), der eine Versorgungsspannung VDD empfängt, wobei wenigstens eine Verzögerungszelle (52) zwischen dem Bereich (51) und der Versorgungsleitung (LVDD) angeordnet ist.

11. Mikroelektronische Vorrichtung nach einem der Ansprüche 1 bis 10, bei der die Gruppe von Speicherzellen zu einer Speichervorrichtung gehört, die ferner ein Modul zur Umwandlung einer virtuellen Speicheradresse in eine physische Speicheradresse umfasst, wobei das Umwandlungsmodul (100) mit einem Dekodierer (102) ausgestattet ist, der zu Folgendem konfiguriert ist: ausgehend von einer virtuellen Adresse, Erzeugen eines Anzeigesignals (ROM_MODE) eines ersten Typs von Speicherzugriff auf Daten, die in die Gruppe von Zellen vorgeladen sind, während der Initialisierungssequenz, oder eines Anzeigesignals eines zweiten Typs von Speicherzugriff auf Daten, die in die Gruppe von Zellen geschrieben sind, nach der Initialisierungssequenz, und Übertragen dieser virtuellen Adresse an ein Verschiebemodul, wobei das Verschiebemodul (104) dazu konfiguriert ist, eine Verschiebeoperation auf eine virtuelle Adresse anzuwenden, um eine physische Adresse zu erzeugen.

## Claims

1. A microelectronic device provided with several superimposed levels (N₁, N₂) of components and comprising:
- a lower level (N₁) provided with one or several components (T₁₁) formed in at least one first semiconducting layer (12),
- an upper level (N₂) comprising transistors (T₂₁, T₂₂) having respective channel regions formed in at least one second semiconducting layer (22) arranged above the first semiconducting layer (12), the device comprising:
- a set of memory cells each provided with a first inverter and a second inverter cross-connected, the first inverter and the second inverter being connected to, and arranged between, a supply line (LVDD) and a ground line (LGND),
the first inverter and the second inverter respectively comprising at least one first transistor (T21) of a first type, N or P, and at least one second transistor (T22) of the first type N or P, belonging to said upper level and each having a lower electrode located between the second semiconducting layer (22) and the first semiconducting layer (12) and coupled by electrostatic coupling with a channel region located in the second semiconducting layer (22),
said cells of said set being furthermore connected to:
- a first biasing line (BIL, BIL2, BIL1) of one among the lower electrode (35a) of the first transistor (T21) and the lower electrode (35b) of the second transistor (T22),
- a second biasing line (BIH, BIH2, BIH1) of the other among the lower electrode (35a) of the first transistor (T21) and the lower electrode (35b) of the second transistor (T22),
the device further comprising a circuit (40, 50) configured for during an initialisation sequence:
- during a first phase apply a first potential (VFBB, VRBB) and a second potential (VRBB, VFBB) different from the first potential, respectively on said first biasing line and said second biasing line, and apply a voltage between said supply line (LVDD) and the ground line (LGND), in such a way as to impose on each cell of said set a logical data of which the value depends on the biasing line among said biasing lines to which the lower electrode of its first transistor (T21) and the lower electrode of its second transistor (T22) are respectively connected,
then
- during a second phase apply the same nominal potential (VNBB, VPBB) on the first biasing line and the second biasing line, and maintain a voltage between said supply line (LVDD) and the ground line (LGND), in such a way as to retain this logical data and render the cells of said set available for read and write access.

2. The microelectronic device according to claim 1, wherein at least one first cell of said set has a lower electrode of its first transistor (T21) which is connected to the first biasing line and a lower electrode of the second transistor (T22) which is connected to the second biasing line, at least one second cell of said set having a lower electrode of its first transistor (T21) which is connected to the second biasing line and a lower electrode of its second transistor (T22) which is connected to the first biasing line, in such a way that during said initialisation sequence, a first logical data is imposed on the first cell, and a second logical data, complementary to the first data is imposed on the second cell.

3. The microelectronic device according to claim 1, wherein the cells of said set respectively comprise at least one third transistor and at least one fourth transistor, with the third transistor and the fourth transistor being of a second type, P or N, opposite the first type, the third transistor and the fourth transistor belonging to said upper level and each having a lower electrode (35a, 35b) located between the second semiconducting layer (22) and the first semiconducting layer (12) and coupled by electrostatic coupling with a channel region located in the second semiconducting layer (22), said cells of said set being furthermore connected to:
- at least one third biasing line of one among the lower electrode of the third transistor and the lower electrode of the fourth transistor,
- at least one fourth biasing line of the other among the lower electrode of the third transistor and the lower electrode of the fourth transistor.

4. The microelectronic device according to claim 3, said circuit (40, 50) being configured during said first phase of the initialisation sequence to:
- apply a pair of different potentials (VFBB, VRBB), respectively on said third biasing line and said fourth biasing line, then
- during the second phase apply the same nominal potential (VNBB, VPBB) on the third biasing line (BIL) and the fourth biasing line (BIH).

5. The microelectronic device according to claim 1, wherein the first transistor (T21) and the second transistor (T22), are:
- respectively, a first load transistor (PU_{L}) and a second load transistor (PU_{R}) of the type P,
or
- respectively, a first conduction transistor (PD_{L}) and a second conduction transistor (PD_{R}) of the type N.

6. The microelectronic device according to claim 5, wherein the first transistor (T21) and the second transistor (T22) are respectively, a first load transistor (PU_{L}) and a second load transistor (PU_{R}) of the type P, the cells of said set each being provided with a first conduction transistor (PD_{L}) having a gate connected to a gate of the first load transistor and with a second conduction transistor(PD_{R}) having a gate connected to a gate of the second load transistor, with the conduction transistors being provided with a lower electrode coupled by electrostatic coupling with a channel region,
the lower electrodes respectively of said first conduction transistor and of said second conduction transistor being set to the same potential (VNBB) during the first phase of the initialisation sequence or being set respectively to a third potential (VRBBn) and to a fourth potential (VFBBn),
or wherein the first transistor (T21) and the second transistor (T22) are respectively, a first conduction transistor and a second conduction transistor of the type N, the cells of said set each being provided with a first load transistor (PU_{L}) having a gate connected to a gate of the first conduction transistor (PD_{L}) and with a second load transistor (PU_{R}) having a gate connected to a gate of the second conduction transistor (PD_{R}), with the conduction transistors being provided with a lower electrode coupled by electrostatic coupling with a channel region,
the lower electrodes respectively of said first load transistor and of said second load transistor being during the first phase of the initialisation sequence: set to the same potential or being set respectively to a third potential (VFBBp) and to a fourth potential (VRBBp).

7. The microelectronic device according to claim 6, wherein said cells of said set are further provided with a first access transistor to the first node and with a second access transistor to the second node, with the first access transistor and the second access transistor each being provided with a lower electrode located between the second semiconducting layer (22) and the first semiconducting layer (12) and coupled by electrostatic coupling with a channel region located in the second semiconducting layer (22).

8. The microelectronic device according to claim 7, wherein the access transistors are of the same type as the first transistor (T21) and the second transistor (T22), with the lower electrodes respectively of said first access transistor (PA_{L}) and of said second access transistor (PA_{R}) being during the first phase of the initialisation sequence: set to the same potential (VNBB, VRBBn) or being set respectively to the first potential (VFBBn) and to the second potential (VRBBn).

9. The microelectronic device according to claim 1, wherein said circuit (40) comprises: a switching element (42) between a portion (41) able to receive a power voltage VDD and the supply line (LVDD), with the switching element being configured to alternatively disconnect then connect the portion (41) to the supply line (LVDD) following a change of state in a first control signal (CMD).

10. The microelectronic device according to claim 1, wherein said circuit (60) comprises: a portion (51) receiving a power voltage VDD, at least one delay cell (52) being arranged between said portion (51) and said supply line (LVDD).

11. The microelectronic device according to claim 1, wherein said set of memory cells belongs to a memory device further comprising a module (100) for converting a virtual memory address into a physical memory address, said conversion module being provided with a decoder (102) configured to: using a virtual address, produce an indicator signal (ROM_MODE) of a first type of access memory to data pre-loaded into said set of cells during said initialisation sequence or an indicator signal of a second type of access memory to data written in said set of cells after said initialisation sequence and transmit this virtual address to a shifter module (104), with the shifter module being configured to apply a shift operation to a virtual address so as to produce a physical address.
